Europäisches Patentamt

European Patent Office

Office européen des brevets

(11) Veröffentlichungsnummer: **0 279 881**
**B1**

(12) **EUROPÄISCHE PATENTSCHRIFT**

(45) Veröffentlichungstag der Patentschrift:
13.09.89

(21) Anmeldenummer: 87102643.1

(22) Anmeldetag: 25.02.87

(51) Int. Cl.⁴: **H01R 23/70**

(54) Verfahren und Verbindungsanordnung zum Anschliessen eines mehrpoligen Steckverbinders an eine Leiterplatte.

(43) Veröffentlichungstag der Anmeldung:
31.08.88 Patentblatt 88/35

(45) Bekanntmachung des Hinweises auf die Patenterteilung:
13.09.89 Patentblatt 89/37

(84) Benannte Vertragsstaaten:
DE GB IT NL SE

(56) Entgegenhaltungen:
DE-A- 1 490 371
DE-B- 1 109 232
GB-A- 2 041 666

(73) Patentinhaber: WINCHESTER ELECTRONICS ZWEIGWERK DER LITTON PRECISION PRODUCTS INTERNATIONAL GMBH, Otto-Hahn-Strasse 8, D-7100 Heilbronn(DE)

(72) Erfinder: Schempp, Otto, Dipl.-Ing., Rembachstrasse 23, D-6927 Bad Rappenau(DE)
Erfinder: Grunow, Werner, Michael-Vehe-Strasse 20, D-7100 Heilbronn-Biberach(DE)

(74) Vertreter: Patentanwälte TER MEER - MÜLLER - STEINMEISTER, Mauerkircherstrasse 45, D-8000 München 80(DE)

## Beschreibung

Die Erfindung betrifft ein Verfahren zum Anschließen eines mehrpoligen Stechverbinders an einer Leiterplatte vorzugsweise im Kantenbereich. Die Erfindung bezieht sich außerdem auf eine Verbindungsanordnung zwischen einem mehrpoligen Steckverbinder und einer Leiterplatte.

Bisher werden Steckverbinder, beispielsweise 96-polige Steckverbinder oder dergleichen, im Kantenbereich von Leiterplatten üblicherweise über metallisierte Durchgangslöcher kontaktiert. Durch neue Oberflächenkontaktierungstechniken ergeben sich jedoch für das Anschließen solcher Steckverbinder besondere nachfolgend erläuterte Probleme. Die Kontaktierung von elektronischen Bauelementen und dergleicher erfolgt bei der kurz auch "Oberflächentechnik" genannten Art der Kontaktierung über sogenannte Gull-Wings oder J-Wings, wobei keine Lötwelle benötigt wird; die Lö tung erfolgt vielmehr durch ein Reflow von aufgetragener Lötpaste. Wird nun für den Anschluß eines normalen Steckverbinders die übliche Lochkontaktierung vorgesehen, so ergibt sich die fertigungstechnisch unerwünschte Notwendigkeit, nur für den Steckverbinder eine sogenannte Lötwelle zu benötigen. Dies ist in einem Fabrikationsprozeß ersichtlicherweise unerwünscht.

Aus diesem Grund wurde bereits vorgeschlagen, die Steckverbinder im Kantenbereich anzuheften, beispielsweise durch Vernieten, und die Anschlüsse nur mehr oder weniger lose mit geringem Andruck auf den vorgesehenen Kontaktstellen aufliegen zu lassen und sodann die Kontaktierung ebenfalls im Reflow-Verfahren durchzuführen. Schwierigkeiten ergeben sich dabei jedoch daraus, daß die vielen Kontakte nicht unbedingt mit genau gleichem Andruck an den vorgesehenen Kontaktstellen anliegen. So kann es geschehen, daß ein Anschlußbeinchen mit größerem Andruck auf der vorgesehenen Kontaktstelle anliegt und ein anderes überhaupt nicht kontaktiert, so daß keine absolute Kontaktsicherheit gewährleistet werden kann. Versieht man andererseits die Anschlüsse mit einer gewissen Federandruckvorspannung, so kann bei einer Vielzahl von Anschlüssen leicht der Fall eintreten, daß sich die Leiterplatte geringfügig durchbiegt, beispielsweise um 0,3 bis 1 mm. Ein einwandfreies leichtes Einstecken einer Leiterkarte in einer vorgesehenen Position ist damit nicht mehr gewährleistet.

Der Erfindung liegt damit die Aufgabe zugrunde, eine Anschlußmöglichkeit für Steckverbinder zu schaffen, durch die es möglich wird, den Steckverbinder im Reflow-Verfahren, also ohne separate Lötwelle, anzuschließen, gleichwohl aber eine sichere Verbindung zu gewährleisten und einen kräftefreien Toleranzausgleich sicherzustellen.

Das erfindungsgemäße Verfahren zum Anschließen eines mehr poligen Steckverbinders vorzugsweise im Kantenbereich einer Leiterplatte, läßt sich dahingehend kennzeichnen, daß die Leiterplatte in Anpassung auf aus dem Gehäuse des Steckverbinders herausgeführten Anschlüsse mit einer der Zahl der Anschlüsse entsprechenden Mehrzahl von Sacklöchern versehen wird, daß die Sacklöcher mit Lotdepot gefüllt werden, daß das Steckergehäuse am vorgesehenen Kantenbereich der Leiterplatte so positioniert wird, daß die freien Enden der Anschlüsse in die Sacklöcher hineinragen und daß die mechanische und elektrische Verbindung des Steckverbinders mit der Leiterplatte durch ein Reflow-Lötverfahren erfolgt.

Eine erfindungsgemäße Anschlußverbindungsanordnung zwischen einem mehrpoligen Steckverbinder und einer Leiterplatte ist erfindungsgemäß dadurch gekennzeichnet, daß die Leiterplatte in Anpassung auf aus dem Steckverbindergehäuse herausgeführte Anschlüsse mit einer der Zahl der Anschlüsse entsprechenden Mehrzahl von Sacklöchern versehen ist, in welche die Enden der Anschlüsse hineinragen und in Reflow-Technik verlötet sind.

Die wesentlichen Vorteile der erfindungsgemäßen Art des Anschließens eines Steckverbinders an eine Leiterplatte gegenüber der herkömmlichen Technik mit durchgebohrten Anschlußlöchern ergeben sich kurz zusammengefaßt wie folgt:

1) Unter den Sacklöchern können Leiterbahnen geführt werden.

2) Aus den Sacklöchern kann die Lötpaste nicht nach unten entweichen; es kann vielmehr ein sicheres Lotdepot und damit eine einwandfreie Kontaktierung gewährleistet werden.

3) Gegenüber den üblichen oberflächenmontierten Anschlüssen (Gull-Wings, J-Wings) ist ein sicherer Toleranzausgleich der Anschlußlängen ohne Kräfteeinleitung in die Leiterplatte gewährleistet, was besonders bei großen vielpoli gen Bauformen von Steckverbindern von besonderem Vorteil ist.

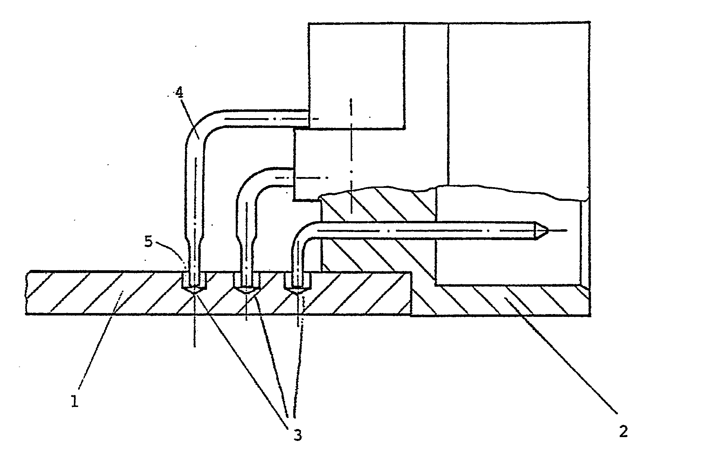

Ein Ausführungsbeispiel der Erfindung wird nachfolgend unter Bezug auf die beigefügte Zeichnung näher erläutert.

Die einzige Figur zeigt in schematischer Darstellung eine Anschlußverbindungsanordnung für einen mehrpoligen Steckverbinder und einer Leiterplatte gemäß der Erfindung.

Das schematisch und im Teilschnitt gezeigte Steckergehäuse 2 ist an den Kantenbereich einer Leiterplatte 1 (im dargestellten Beispiel formschlüssig) angepaßt. Aus dem Steckergehäuse 2 ragen seitlich im dargestellten Beispiel drei Reihen von Anschlüssen 4 heraus, die in der dargestellten Weise nach unten abgekröpft sind. Die Leiterplatte 1 ist mit einer der Anzahl der Anschlüsse 4 entsprechenden Mehrzahl von Sacklöchern 3 versehen. Zum Anschließen des Steckverbinders wird Lötpaste in die Sacklöcher 3 eingebracht. Sodann wird das Steckergehäuse positionsgerecht an die Leiterplatte 1 angesetzt, so daß die greien Enden der abgekröpften Anschlüsse 4 in die Sacklöcher 3 hineinragen. Das Steckergehäuse kann jetzt zusammen mit allen übrigen (nicht gezeigten) elektronischen und elektrischen Bauelementen und Baugruppen auf der Leiterplatte 1 im Reflow-Verfahren verlötet werden.

Die Erfindung bietet herstellungstechnisch deutliche Kostenvorteile, gewährleistet eine sichere mechanische und elektrische Verbindung von Leiterplatte 1 und Seckergehäuse 2, ohne daß Verformungen der Leiterplatte zu befürchten sind.

## Patentansprüche

1. Verfahren zum Anschließen eines mehrpoligen Steckverbinders an einer Leiterplatte vorzugsweise im Kantenbereich (1), **dadurch gekennzeichnet, daß**
— die Leiterplatte (1) in Anpassung auf aus dem Steckverbindergehäuse (2) herausgeführte Anschlüsse (4) mit einer der Zahl der Anschlüsse (4) entsprechenden Mehrzahl von Sacklöchern (3) versehen wird,
— die Sacklöcher (3) mit Lotdepot (5) gefüllt werden,
— das Steckergehäuse (2) am vorgesehenen Anschlußbereich der Leiterplatte so positioniert wird, daß die freien Enden der Anschlüsse (4) in die Sacklöcher (3) hineinragen, und daß
— die mechanische und elektrische Verbindung des Steckverbinders mit der Leiterplatte (1) durch ein Reflow-Lötverfahren erfolgt.

2. Anschlußverbindungsanordnung zwischen einem mehrpoligen Steckverbinder (2) und einer Leiterplatte (1), **dadurch gekennzeichnet, daß**
— die Leiterplatte (1) in Anpassung auf aus dem Steckverbindergehäuse (2) herausgeführte Anschlüsse (4) mit einer der Zahl der Anschlüsse (4) entsprechenden Mehrzahl von Sacklöchern (3) versehen ist, in welche die Enden der Anschlüsse hineinragen und verlötet sind.

3. Anschlußverbindungsanordnung nach Anspruch 2, **dadurch gekennzeichnet,** daß die Anschlüsse (4) längsseitlich aus dem Steckergehäuse (2) herausragen und in Ausrichtung auf die reihenweise angeordneten Sacklöcher (3) in der Leiterplatte abgekröpft und reflow-verlötet sind.

## Claims

1. Method for the connection of a multipole connector to a circuit board (1), preferably in the edge region, characterized in that
— the circuit board (1) is provided with a plurality of blind holes (3), equivalent in number to and matching the terminals (4) brought out of the connector housing (2),
— the blind holes (3) are filled with solder (5),
— the connector housing (2) is positioned at the intended connection region of the circuit board in such a way that the free ends of the terminals (4) project into the blind holes (3) and in that
— the mechanical and electrical connection of the connector to the circuit board (1) is carried out by a reflow soldering method.

2. Terminal connection arrangement between a multiple connector (2) and a circuit board (1), characterized in that
— the circuit board (1) is provided with a plurality of blind holes (3), equivalent in number to and matching the terminals (4) brought out of the connector housing (2), into which blind holes the ends of the terminals project and are soldered.

3. Terminal connection arrangement according to Claim 2, characterized in that the terminals (4) project longitudinally sideways from the connector housing (2) and are bent off in alignment with the blind holes (3) arranged in rows in the circuit board and are reflow-soldered.

## Revendications

1. Procédé de connexion d'une prise multipolaire à une plaque de circuit imprimé (1), de préférence, au niveau d'un bord, caractérisé en ce que
— la plaque de circuit imprimé (1) est pourvu d'un nombre de trous borgnes (3) équivalant au nombre de liaisons (4) en correspondance avec les liaisons (4) sorties du logement de la prise (2),
— les trous borgnes (3) sont remplis de dépôt de soudure à l'étain (5),
— le logement de prise (2) est positionné de telle sorte, au niveau de la zone de raccordement prévue, que les extrémités libres des liaisons (4) viennent se loger dans les trous borgnes (3), et que
— la liaison mécanique et électrique de la prise avec la plaque de circuits imprimés (1) s'effectue par un procédé de soudure à la vague.

2. Dispositif de connexion pour brancher une prise multipolaire (2) à une plaque de circuit imprimé (1), caractérisé en ce que
— la plaque de circuit (1) est pourvue d'un nombre de trous borgnes (3) équivalant au nombre de liaisons (4), en correspondance avec les liaisons (4) sorties du logement de la prise (2); les extrémités libres des connexions venant se loger dans les trous borgnes où elles sont soudées.

3. Un dispositif de connexion, selon la revendication 2, caractérisé en ce que les liaisons (4) sortent du logement de la prise (2) en longeant le bord, sont courbées en direction des trous borgnes (3) disposés en rangs dans la plaque de circuit imprimé, et sont soudées à la vague.